# EUROPÄISCHE PATENTSCHRIFT

(11) **EP 2 691 864 B1**
(45) Veröffentlichungstag und Bekanntmachung des Hinweises auf die Patenterteilung: **14.09.2016**
(21) Anmeldenummer: 12716267.5
(22) Anmeldetag: 21.03.2012
(51) Int. Cl.: G06F 13/40, H05K 7/14

(54) **BAUGRUPPENTRÄGER, SERVER SOWIE ANORDNUNG MIT EINEM DERARTIGEN BAUGRUPPENTRÄGER UND ZUMINDEST EINEM SERVER**
RACK, SERVER AND ASSEMBLY COMPRISING SUCH A RACK AND AT LEAST ONE SERVER
CHÂSSIS, SERVEUR AINSI QU'ENSEMBLE COMPRENANT LEDIT CHÂSSIS ET AU MOINS UN SERVEUR

(30) Priorität: 30.03.2011 DE 102011015548; 18.04.2011 DE 102011017386
(43) Veröffentlichungstag der Anmeldung: 05.02.2014
(73) Patentinhaber: Fujitsu Technology Solutions Intellectual Property GmbH, 80807 München (DE)
(72) Erfinder: LÜCK, Thomas, 86179 Augsburg (DE)
(74) Vertreter: Epping - Hermann - Fischer
(86) Internationale Anmeldenummer: PCT/EP2012/055005
(87) Internationale Veröffentlichungsnummer: WO 2012/130691

(56) Entgegenhaltungen:
- EP-A2- 0 486 208
- WO-A-2009/096974
- WO-A1-2010/080158
- JP-A- 11 266 088
- US-B1- 7 291 032

## Beschreibung

Die Erfindung betrifft einen Baugruppenträger mit einem Einschubschacht zur Aufnahme von Servern, wobei der Einschubschacht zwei gegenüberliegende Innenbereiche im Gehäuse definiert, welche parallel zu einer Einschubrichtung der Server angeordnet sind und Innenwände ausbilden, wobei die Innenwände in eine Vielzahl von Einschubplätzen unterteilt sind, und wobei im Baugruppenträger eine oder mehrere Datenleitungen zur Datenverbindung von Servern eingerichtet sind.

Ferner betrifft die Erfindung einen Server, welcher dazu eingerichtet ist, in einen Einschubplatz eines entsprechenden Baugruppenträgers eingeschoben zu werden.

Server, welche in einen Baugruppenträger eingeschoben sind, werden typischerweise von vorne und/oder von hinten (das heißt an den Flächen senkrecht zur Einschubrichtung) zum Datenaustausch sowie zur Stromversorgung über elektrische Leitungen kontaktiert. Eine elektrische Kontaktierung erfolgt entweder mit einer Backplane oder Midplane in dem Baugruppenträger oder unmittelbar über elektrische Leitungen zu einem weiteren Server, einer Datenvermittlungseinheit (z.B. Switch) oder zu einer Stromversorgungseinheit. Da die Server typischerweise durch einen Luftstrom in Einschubrichtung am Baugruppenträger gekühlt werden, können die diversen Anschlüsse den Luftdurchlass unter Umständen stark behindern.

Es existieren bereits Lösungen, die Anzahl der Anschlüsse beziehungsweise die von diesen benötigte Fläche auf der Vorder- und/oder Rückseite der Server durch schmalen Aufbau möglichst gering zu halten. Auf diese Weise kann mehr Fläche zum Durchströmen eines Kühlluftstroms gewonnen werden. Weitere Lösungen sehen eine verbesserte Gestaltung der Datenverbindungen selbst vor, welche die benötigte Fläche weiter reduzieren. Insbesondere der Einsatz von optischen Datenverbindungen findet hier immer stärkeren Einfluss. Diese Lösungen erlauben jedoch nur eine begrenzte Verbesserung im Hinblick auf den Luftdurchsatz im Baugruppenträger.

Die internationale Anmeldung mit der Veröffentlichungsnummer WO2009/096974 offenbart einen Baugruppenträger mit einschiebbaren Server-Modulen, die über optische Schnittstellen kommunizieren.

Es ist eine Aufgabe der Erfindung, ein Baugruppenträger, einen Server sowie eine Anordnung mit einem Baugruppenträger und einem Server der eingangs genannten Art zu beschreiben, wodurch eine verbesserte Kühlwirkung von Servern in einem Baugruppenträger erzielt ist und dennoch eine Datenverbindung mit einem hohen Datendurchsatz zur Datenverbindung der Server im Baugruppenträger geschaffen ist.

Diese Aufgabe wird in einem ersten Aspekt durch einen Baugruppenträger der eingangs genannten Art dadurch gelöst, dass die Datenleitungen optische Datenleitungen umfassen, wobei an zumindest einem der zwei Innenbereiche des Einschubschachtes an jedem Einschubplatz ein Endabschnitt einer Datenleitung mit einer Datenschnittstelle angeordnet ist, derart dass eine berührungslose optische Datenverbindung zu einer weiteren Datenschnittstelle an einem entsprechenden Server ermöglicht ist.

Eine derartige Lösung hat mehrere Vorteile. Zum einen sind die Datenschnittstellen zur Datenverbindung von in dem Einschubschacht eingeschobenen Servern von einer Fläche senkrecht zur Einschubrichtung verlegt an eine Fläche, welche parallel zur Einschubrichtung im Einschubschacht liegt. Das bedeutet, dass Flächen senkrecht zur Einschubrichtung von Servern mit weniger oder unter Umständen vollkommen frei von Anschlüssen gestaltet werden können. Durch diese Anordnung ist erreicht, dass Datenschnittstellen nicht mehr im Luftstrom eines Kühlluftstroms durch den Baugruppenträger liegen, wodurch die Kühlung beeinträchtigt würde. Auch das Problem, dass Glasfaserkontakte der optischen Datenverbindungen eventuell empfindlich auf Temperaturänderungen reagieren, könnte dadurch umgangen sein, dass die Kontakte nun nicht mehr im Luftstrom liegen und unter Umständen mit einem Temperaturgradienten belastet werden.

Der Begriff "Baugruppenträger" umfasst in diesem Kontext sämtliche tragenden Aufbauten zum Aufnehmen von einem oder mehreren Einschubgeräten, insbesondere Servern. So kann ein Baugruppenträger beispielsweise ein Serverrack bilden. Dieses Serverrack kann ein Gehäuse mit Wandungen zur stabilen und geschützten Unterbringung von Servern aufweisen oder lediglich als Rahmenaufbau fungieren. Der Baugruppenträger kann aber auch ein rahmenförmiges Chassis mit Wandungen bilden, wie es beispielsweise zur Unterbringung und Verschaltung von Blade-Servern in entsprechenden Systemen Verwendung findet.

Der Begriff "Innenbereich" im Einschubschacht umfasst hier einen Bereich, welcher durch die (seitlichen) Begrenzungen des Einschubschachts durch den Baugruppenträger gebildet ist. Der Innenbereich kann im Falle eines lediglich rahmenförmigen Aufbaus des Baugruppenträgers beispielsweise aus einer Aneinanderreihung von tragenden Elementen für die Server ausgebildet sein. Falls der Einschubschacht Wandungen im Baugruppenträger ausbildet, so kann der Innenbereich auch als Innenwand des Einschubschachtes ausgeführt sein.

Die Endabschnitte der Datenleitungen mit den Datenschnittstellen sind derart angeordnet, dass pro Einschubplatz im Baugruppenträger zumindest eine Datenschnittstelle zur Datenverbindung mit einem Server eingerichtet ist, welcher in diesen Einschubplatz eingeschoben ist. Dabei ist denkbar, nur an einem oder an beiden entsprechenden Innenbereichen im Baugruppenträger Endabschnitte der Datenleitungen mit Datenschnittstellen vorzusehen.

Zum anderen erlaubt die Lösung aufgrund der Einrichtung einer optischen Datenverbindung zwischen einem eingeschobenen Server und dem Baugruppenträger einen hohen Datendurchsatz mit Datenraten im Bereich Gbit/s. Zudem ist der Vorteil der berührungslosen optischen Datenverbindung gegeben, wodurch Verschleißteile wie Stecker und Steckerkontakte hierfür vollständig entfallen. Ein Verkanten oder Beschädigen dieser Steckerkontakte bei Einschieben eines Servers in den Baugruppenträger ist somit ausgeschlossen.

Unter Umständen erlaubt eine derartige Datenverbindung auch eine kompaktere und platzsparendere Ausführung der Datenschnittstellen, da Bauraum für Stecker und Steckerkontakte eingespart werden kann. Insbesondere kann die berührungslose optische Datenverbindung derart eingerichtet sein, dass die Datenverbindung lediglich über wenige Millimeter zwischen dem Baugruppenträger und einem Server aufgebaut wird.

Bevorzugt sind im Baugruppenträger und/oder in einem eingeschobenen Server selbst Mittel eingerichtet zur Erzeugung eines Kühlluftstromes derart, dass die Richtung des Kühlluftstroms parallel zur Einschubrichtung der Server ausgebildet ist. Die Datenschnittstellen zur optischen Datenverbindung liegen nicht senkrecht zum Kühlluftstrom, sondern an Innenbereichen parallel zum Kühlluftstrom. Dadurch wird der Kühlluftstrom nicht beeinträchtigt. Vielmehr kann der Kühlluftstrom Lüftungsöffnungen durchströmen, welche durch Verlegen der Datenschnittstellen von Flächen senkrecht zur Einschubrichtung hin zu Flächen parallel zur Einschubrichtung geschaffen sind.

Zur Ausgestaltung der optischen Datenverbindungen über die Datenschnittstellen können verschiedene Lösungen herangezogen werden. Insbesondere sind die Endabschnitte der Datenleitungen mit den Datenschnittstellen vorteilhaft zu einem entsprechenden Server hin gerichtet und weisen jeweils einen Lichtwellenleiter auf. Die Endabschnitte können z.B. ein Glasfaserkabel als Lichtwellenleiter, sowie eine daran anschließende Optik, insbesondere eine Anordnung mit zumindest einer Linse, zum Ein- und Auskoppeln von Lichtwellen aufweisen. Eine derartige Ausgestaltung beruht darauf, dass Lichtsignale von einer Glasfaser über eine Linsenanordnung in die andere Glasfaser geleitet werden. Die Linsenanordnung erlaubt dabei ein Bündeln der Lichtwellen sowie ein gerichtetes Ein- und Auskoppeln von Lichtwellen in oder aus einer Glasfaser.

Vorteilhaft weisen die Endabschnitte der Datenschnittstellen jeweils eine Anordnung von einem oder mehreren Justierelementen auf, die zum feinmechanischen Ausrichten der Optik eingerichtet sind. Eine ausschließlich grobmechanische Ausrichtung von Glasfasern zur optischen Datenverbindung ist insbesondere wegen mechanischer Fertigungstoleranzen oder bei Vibrationen in einem Computersystem, welche beispielsweise durch rotierende Teile optischer Laufwerke oder Festplatten ausgelöst werden, nicht ausreichend. Deshalb werden die Endabschnitte mit der Optik schwimmend im Baugruppenträger gelagert. Die Feinjustierung erfolgt durch die Justierelemente, welche beispielsweise als Permanent- und/oder Elektromagnete oder Piezoelemente zum Ausrichten der Endabschnitte hin zu weiteren Endabschnitten von Datenschnittstellen an Servern eingerichtet sind. Im Falle der Ausführung als Elektromagnete oder Piezoelemente ist eine Ansteuerelektronik entsprechend vorzusehen.

Vorteilhaft sind die gesamten Endabschnitte mit den Datenschnittstellen - nicht nur deren Optik - in ihrer Position an der Innenwand des Einschubplatzes im Einschubschacht veränderlich. Dies bietet den Vorteil, dass die Endabschnitte in ihrer Position an eine Einbautiefe (in Einschubrichtung) und/oder Einbauhöhe (senkrecht zur Einschubrichtung) eines eingeschobenen Servers angepasst werden können, beispielsweise zum Ausrichten hin zu einer weiteren Datenschnittstelle am Server. Die Endabschnitte können beispielsweise über vorgefertigte Montagevorrichtungen in ihrer Position flexibel gestaltet werden.

Bevorzugt sind die Datenleitungen im Baugruppenträger geführt und mit einer im Baugruppenträger angeordneten Vermittlungseinheit verbunden zum selektiven Verschalten von Servern, welche eine berührungslose optische Datenverbindung zu einer Datenschnittstelle im Baugruppenträger aufgebaut haben oder aufbauen wollen. Eine derartige Vermittlungseinheit kann beispielsweise ein sog. Switch oder Router zum Weitervermitteln von Datenverbindungen sein. Alternativ können die Datenleitungen zur weiteren Verbindung auch einfach aus dem Baugruppenträger herausgeführt werden, um von dort auf herkömmliche Art mit weiteren Komponenten und Geräten in einer Serverarchitektur kontaktiert zu werden. Es bietet sich hier an, die Datenleitungen seitlich an den Innenbereichen mit den Endabschnitten der Datenschnittstellen entlang an eine Vorder- oder Rückseite des Baugruppenträgers zu führen. Dort kann eine weitere Kontaktierung erfolgen.

In einem zweiten Aspekt wird die Aufgabe durch einen Server gelöst, welcher dazu eingerichtet ist, in einen Einschubplatz eines Baugruppenträgers eingeschoben zu werden und welcher zumindest an einer Außenwand einen Endabschnitt einer optischen Datenleitung mit einer Datenschnittstelle aufweist, welche dazu eingerichtet ist, eine berührungslose optische Datenverbindung zu einer Datenschnittstelle des Baugruppenträgers zu ermöglichen.

Bevorzugt kann der Endabschnitt der Datenleitung mit der Datenschnittstelle im Server auf gleiche oder ähnliche Art ausgeführt sein, wie bereits zur Datenschnittstelle im Baugruppenträger erläutert wurde. Insbesondere eine schwimmende Lagerung und Feinjustage einer Optik über Justierelemente kann auch hier eingerichtet sein.

Vorzugsweise ist auch der Endabschnitt der Datenschnittstelle im Server in seiner Position an der Außenwand des Servers veränderlich. Auch hier kann, wie bereits zum Baugruppenträger erläutert, eine Montagevorrichtung Anwendung finden, um die Position des Endabschnitts der Datenschnittstelle im Server an die Position des Endabschnitts der Datenschnittstelle im Baugruppenträger derart anzupassen, dass beide Datenschnittstellen trotz veränderlicher Einbautiefe eines Servers im Einschubschacht des Baugruppenträgers ermöglicht ist.

In einem dritten Aspekt wird die Aufgabe durch eine Anordnung mit einem Baugruppenträger der genannten Art und zumindest einem Server der genannten Art gelöst, welcher in einen Einschubplatz des Einschubschachts eingeschoben ist. Der Server weist seinen Endabschnitt der optischen Datenleitung mit der Datenschnittstelle zumindest an einer Außenwand auf, welche parallel zum entsprechenden Innenbereich am Einschubplatz angeordnet ist, wobei die Datenschnittstelle des Servers derart auf Höhe der Datenschnittstelle des Einschubplatzes angeordnet ist, dass eine berührungslose optische Datenverbindung zwischen den beiden Datenschnittstellen ermöglicht ist.

Der Server sowie die Anordnung mit einem Baugruppenträger und einem Server ermöglichen eine seitliche Kontaktierung des Servers, welcher in den Baugruppenträger eingeschoben ist über eine optische berührungslose Datenverbindung zum Baugruppenträger. Der Server weist einen Endabschnitt eines entsprechenden Verbindungsmoduls mit einer Datenschnittstelle zum optischen Datenaufbau zu dem entsprechenden Endabschnitt im Einschubplatz des Baugruppenträgers auf. Bei der Anordnung sind die beiden Endabschnitte derart angeordnet, dass sie in Deckung kommen, wenn der Server vollständig in den Einschubplatz im Einschubschacht eingeschoben ist.

Weitere vorteilhafte Ausgestaltungen sind in den Unteransprüchen sowie in der nachfolgenden Figurenbeschreibung offenbart.

Die Erfindung wird anhand mehrerer Zeichnungen in Figuren näher erläutert.

Es zeigen:
- Figur 1: eine perspektivische Darstellung einer Anordnung mit einem Baugruppenträger und einem Server,
- Figur 2: ein schematisiertes Schnittbild durch einen Teil des Gehäuse eines Baugruppenträgers und einen Teil eines Servers,
- Figur 3: eine perspektivische Darstellung eines Teils eines Servers,
- Figur 4: eine perspektivische Darstellung eines Teils einer Innenwand eines Gehäuse und
- Figur 5: einen schematisierten Aufbau wesentlicher Komponenten einer optischen berührungslosen Datenverbindung.

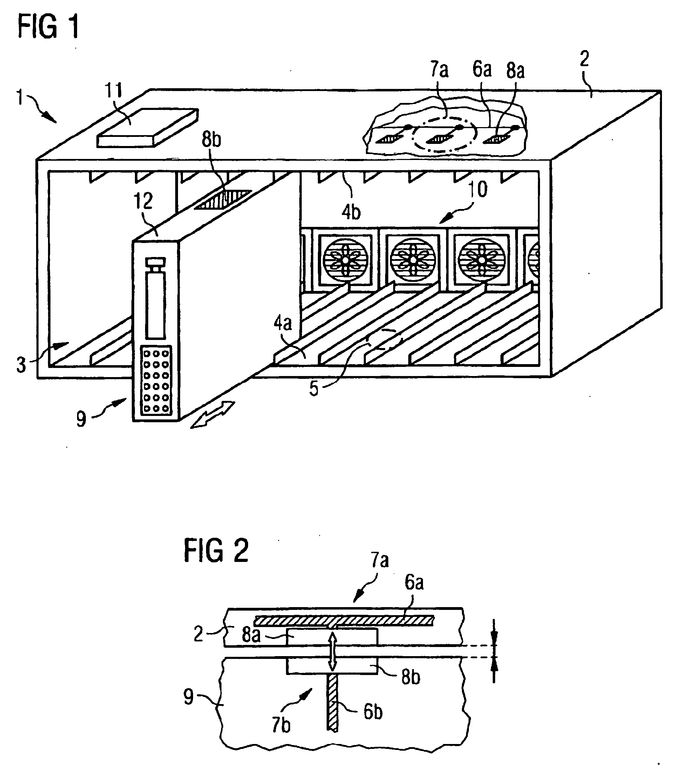

Figur 1 zeigt eine perspektivische Darstellung einer Anordnung mit einem Baugruppenträger 1 und einem Server 9.

Der Baugruppenträger 1 weist ein Gehäuse 2 zur Aufnahme von Einschubkomponenten, insbesondere Servern oder Bladeservern, auf. Im Gehäuse 2 ist ein Einschubschacht 3 zur Aufnahme von Servern 9 eingerichtet. Der Einschubschacht 3 definiert insbesondere zwei Innenbereiche, welche Innenwände 4a und 4b am Gehäuse 2 ausbilden, wobei die Innenwände 4a und 4b in eine Vielzahl von Einschubplätzen 5 unterteilt sind. Jeder Einschubplatz 5 dient zur Aufnahme eines Servers 9. Zur Aufnahme, zum Halten und Tragen des Servers 9 können, wie hier schematisiert angedeutet, Halteelemente und Führungsschienen an einem jeweiligen Einschubplatz 5 vorgesehen sein.

An einer Rückwand im Einschubschacht 3 sind zudem Lüfter 10 angeordnet zum Erzeugen eines Kühlluftstroms parallel zu einer Einschubrichtung (siehe Pfeilrichtung) eines Servers 9 in den Einschubschacht 3. Auf diese Weise kann ein in den Einschubschacht 3 eingeschobener Server 9 aktiv gekühlt werden.

Zur Datenverbindung weist der Baugruppenträger 1 eine Datenleitung 6a auf, welche vorteilhaft als optische Datenleitung, beispielsweise über Glasfaser oder sonstige Lichtwellenleiter, ausgeführt ist. Die Datenleitung 6a ist in der Innenwand 4b am Gehäuse 2 integriert. In Höhe eines jeden Einschubplatzes 5 weist die Datenleitung 6a Endabschnitte 7a auf, an denen Datenschnittstellen 8a entspringen. Das Gehäuse 2 weist somit an jedem Einschubplatz 5 die Möglichkeit auf, eine optische Datenverbindung zu einem in den Einschubplatz 5 eingeschobenen Server 9 aufzubauen, wie nachfolgend näher erläutert wird. Es ist denkbar, weitere solcher Datenschnittstellen 6a auch in die Innenwand 4a auf der Unterseite des Baugruppenträgers 1 zu integrieren.

Vorteilhaft ist die Datenleitung 6a mit den Endabschnitten 7a und den daran entspringenden Datenschnittstellen 8a von einer Rückwand des Gehäuse 2 fort verlagert an die Innenwand 4b (oder 4a), welche parallel zu einer Einschubrichtung von Servern 9 angeordnet ist. Somit liegen die Datenschnittstellen 8a nicht senkrecht zur Einschubrichtung eines Servers 9 oder zu einem Luftstrom durch den Baugruppenträger 1. Vielmehr ist an der Rückwand des Gehäuse 2 freier Platz geschaffen zum Einrichten von Lüftungsöffnungen oder, wie hier dargestellt, zum Einrichten von Lüftern 10 zum Erzeugen eines Kühlluftstromes parallel zur Einschubrichtung der Server 9 durch den Einschubschacht 3.

Der teilweise in einen Einschubplatz 5 eingeschobene Server 9 weist an einer Außenwand 12, welche parallel zur Innenwand 4b des Gehäuses 2 eingerichtet ist, eine weitere Datenschnittstelle 8b auf. Wird der Server 9 in Einschubrichtung vollständig in den Einschubplatz 5 eingeschoben, so kommt die Datenschnittstelle 8b auf Höhe einer entsprechenden Datenschnittstelle 8a im Einschubplatz 5 derart zu liegen, dass eine optische berührungslose Datenverbindung zwischen den Datenschnittstellen 8a und 8b aufgebaut werden kann. Auch durch Verlagern der Datenschnittstelle 8b von einer Rückwand des Servers 9 an die seitliche Außenwand 12 ist erreicht, dass an den Gehäusewänden senkrecht zur Einschubrichtung am Server 9 freier Platz für Lüftungsöffnungen zum Durchströmen des Servers 9 mit Kühlluft geschaffen ist.

Zur Vermittlung von Datenverbindungen zwischen einem Server 9 und dem Baugruppenträger 1 beziehungsweise zwischen mehreren Servern 9 ist an der Oberseite des Gehäuses 2 eine Vermittlungseinheit 11 eingerichtet. Die Vermittlungseinheit 11 kann beispielsweise ein Switch oder Router sein zur Vermittlung von Datenverbindungen zwischen Servern 9. Insbesondere mündet die Datenleitung 6a oder auch weitere Datenleitungen (nicht dargestellt), beispielsweise eines Management-Bussystems oder anderer Kommunikationskanäle, in die Vermittlungseinheit 11, welche auch mehrfach ausgelegt sein kann. Die Vermittlungseinheit 11 stellt somit einen zentralen Knotenpunkt des Baugruppenträgers 1 bezüglich der Datenverbindung zwischen unterschiedlichen Einschubkomponenten dar.

Es ist jedoch auch denkbar alternativ zur Ausführung gemäß Figur 1 Datenleitungen, insbesondere die optische Datenleitung 6a an den Wänden des Gehäuse 2 entlang nach vorne oder hinten am Baugruppenträger 1 abzuführen, so dass externe Komponenten (nicht dargestellt) mit der Datenleitung 6a verbunden werden können. Dies erlaubt auch eine Vermittlung von Daten an die Umgebung des Baugruppenträgers 1, was beispielsweise in einer Struktur mit mehreren Baugruppenträgern 1 Anwendung finden kann.

Figur 2 zeigt einen schematisierten Schnitt durch einen Teil des Gehäuses 2 und einen Teil eines Servers 9, welcher in den Einschubschacht 3 gemäß Figur 1 vollständig eingeschoben ist. Insbesondere veranschaulicht Figur 2 die bündige und deckungsgleiche Anordnung der beiden Datenschnittstellen 8a und 8b, wobei die Datenschnittstelle 8a im Gehäuse 2 und die Datenschnittstelle 8b im Server 9 angeordnet sind. Der Server 9 ist derart bündig am Gehäuse 2 angeordnet, dass der Abstand zwischen den beiden optischen Datenschnittstellen 8a und 8b sehr gering gehalten werden kann, beispielsweise wenige Millimeter. Auch durch die Tatsache, dass die Datenschnittstellen 8a und 8b in die jeweiligen Wände integriert sind und keine zusätzliche Bauhöhe aufweisen, ist eine platzsparende Integration erreicht, welche an den Einbauabstand zwischen dem Gehäuse 2 und dem Server 9 angepasst ist.

Figur 2 veranschaulicht die jeweiligen Endabschnitte 7a und 7b, welche aus Lichtwellenleitern der Datenleitungen 6a und 6b sowie aus daran anschließenden Datenschnittstellen 8a und 8b ausgeführt sind. Über die Lichtwellenleiter der Datenleitungen 6a und 6b können somit Daten zu den Datenschnittstellen 8a und 8b hin oder von diesen weg transportiert werden. Die Lichtwellenleiter der Datenleitungen 6a und 6b können beispielsweise als Glasfaserkabel ausgebildet sein. Insbesondere können die Glasfasern als sogenannte Gradientenfasern mit radial abnehmender Brechzahl oder als sogenannte Stufenindexfasern mit diskret abgegrenztem Brechungsindex ausgeführt sein. Letztere finden als Multimode- oder Monomodefasern Anwendung. Der Vorteil von Multimodefasern besteht darin, dass unterschiedliche Wellenlängen (Moden) transportiert werden können, wodurch Signale unterschiedlicher Frequenz parallel übertragen werden können. Insbesondere über kleinere Entfernungen bieten Multimodefasern eine störsichere Informationsübertragung bei guter Kanalaufteilung.

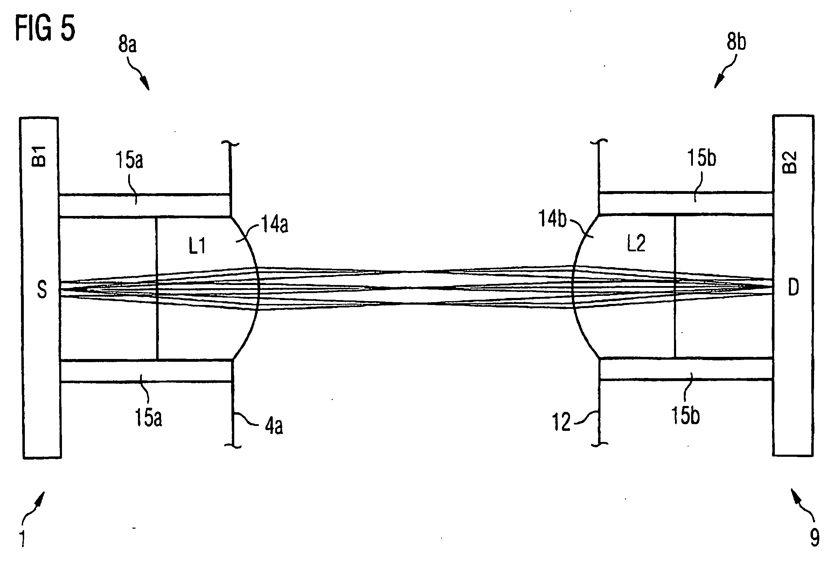

Figur 2 zeigt lediglich schematisiert den Aufbau der Anordnung, wobei insbesondere die Datenleitungen 6a und 6b derart auszuführen sind, dass eine verlustminimierte Weiterleitung von Lichtwellen in den Lichtwellenleitern ermöglicht ist. Optische Signale können an die Datenschnittstellen 8a und 8b weitergeleitet oder von diesen aufgenommen werden (siehe Doppelpfeil zwischen den Datenschnittstellen 8a und 8b). Insbesondere weisen die Datenschnittstellen 8a und 8b Komponenten zum Senden und Empfangen von Lichtwellensignalen auf. Ein detaillierter Aufbau der Datenschnittstellen 8a und 8b wird in Figur 5 näher erläutert.

Aufgrund der deckungsgleichen Anordnung der Datenschnittstellen 8a und 8b an Wänden parallel zur Einschubrichtung des Servers 9 (siehe Figur 1) ist eine Datenverbindung zwischen dem Server 9 und dem Gehäuse 2 des Baugruppenträgers 1 ermöglicht, ohne dass eine derartige Datenverbindung an der Rückwand des Gehäuse 2 senkrecht zur Einschubrichtung eingerichtet werden muss. Aufgrund der kompakten Ausführung der Datenverbindung zwischen den Datenschnittstellen 8a und 8b entfallen mechanische Steckverbindungen zwischen dem Gehäuse 2 und dem Server 9. Insbesondere durch berührungslose optische Datenverbindung zwischen dem Server 9 und dem Gehäuse 2 ist das Einrichten der Datenverbindung völlig unabhängig von einer mechanischen Verbindung des Servers 9 mit dem Gehäuse 2.

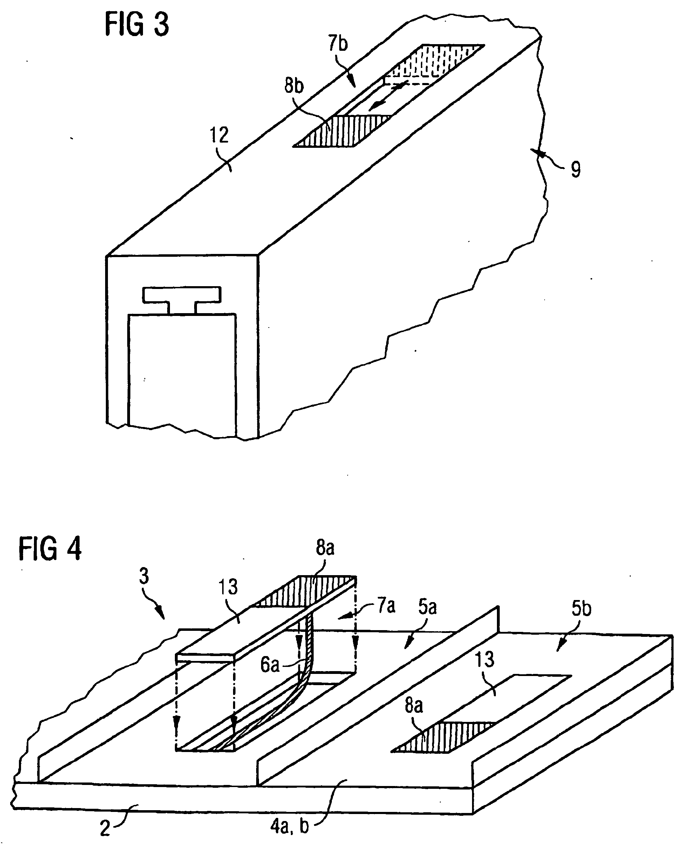

Figur 3 zeigt eine perspektivische Darstellung eines Teils des Servers 9, wobei an der Außenwand 12 des Servers 9 der Endabschnitt 7b mit der Datenschnittstelle 8b angeordnet ist. An der Außenwand 12 ist die Datenschnittstelle 8b in ihrer Position veränderlich. Das bedeutet sie kann in eine Vielzahl von Positionen an der Außenwand gebracht werden, so dass die Position der Datenschnittstelle 8b an eine Position einer korrespondierenden Datenschnittstelle 8a gemäß den Figuren 1 und 2 derart angepasst werden kann, dass die beiden Datenschnittstellen 8a und 8b auf gleicher Höhe und deckungsgleich angeordnet sind. Auf diese Weise kann die Datenschnittstelle 8b an unterschiedliche Abmessungen und Einbautiefen von Servern 9 bezogen auf die Position der Datenschnittstelle 8a im Gehäuse 2 des Baugruppenträgers 1 angepasst werden.

Figur 4 zeigt eine perspektivische Darstellung eines Teils des Gehäuse 2, insbesondere einer Innenwand 4a oder 4b, welche in mehrere Einschubplätze unterteilt ist und den Einschubschacht 3 definiert. Insbesondere sind zwei Einschubplätze 5a und 5b dargestellt, welche jeweils eine Datenschnittstelle 8a zur optischen Datenverbindung mit einer Datenschnittstelle 8b eines Servers 9 gemäß den Figuren 1 bis 3 aufweisen.

Die Datenschnittstellen 8a sind an Montagevorrichtungen 13 angeordnet. Über die Montagevorrichtungen 13, welche plattenförmig ausgeführt sind, können die Datenschnittstellen 8a in dieser Ausführung beispielhaft in zwei Positionen am Gehäuse 2 festgelegt werden. Eine erste Position ergibt sich aus dem linken Einschubplatz 5a, wobei die Datenschnittstelle 8a zu einer Rückwand hin ausgerichtet wird. Der linke Einschubplatz 5a zeigt dabei die Datenschnittstelle 8a mit der Montagevorrichtung 13 in einer noch nicht vollständig montierten Position. Von der Datenschnittstelle 8a entspringt am Endabschnitt 7a die Datenleitung 6a, welche in Form einer Glasfaser oder eines sonstigen Lichtwellenleiters in das Gehäuse 2 hineingeführt wird. Schließlich kann die Montagevorrichtung 13 nach unten in eine Montageöffnung am Gehäuse 2 eingesetzt und dort über Rastmittel (nicht dargestellt) festgelegt werden. Dabei ist vorzusehen, dass die Datenleitung 6a entsprechend derart mitgeführt wird, dass sie einer Montage der Montagevorrichtung 13 nicht entgegensteht oder Schaden nimmt. Auf diese Weise kann die Datenschnittstelle 8a in einer rückwärtigen Position am Einschubschacht 5a des Gehäuses 2 festgelegt werden.

Der rechte Einschubschacht 5b zeigt die bereits fertig montierte Datenschnittstelle 8a in einer zweiten Position, welche von einer Rückwand entfernt zu einer Vorderseite des Gehäuses 2 hin gelegen ist. Die entsprechende Montagevorrichtung 13 wurde dabei beispielsweise um 180° verdreht und anschließend in die Montageöffnung eingesetzt, so dass die Datenschnittstelle 8a in der gezeigten Position festgelegt ist.

Auf diese Weise kann über die Montagevorrichtung 13 die Position einer Datenschnittstelle 8a an einem Einschubplatz 5a oder 5b des Gehäuse 2 verändert werden, so dass die Position der Datenschnittstelle 8a an unterschiedliche Positionen von Datenschnittstellen 8b an Servern 9 angepasst werden kann.

Neben den dargestellten Ausführungsformen ist es freilich denkbar, alternative Ausführungen der Montagevorrichtungen 13 vorzusehen. Dabei können beispielsweise Schienenaufbauten vorgesehen sein zum Verschieben der Datenschnittstellen 8a in unterschiedliche Positionen ähnlich zur Ausführung gemäß Figur 3.

Figur 5 zeigt einen beispielhaften Aufbau zumindest eines Teils der Datenschnittstellen 8a und 8b am Baugruppenträger 1 und am Server 9, welche sich im eingebauten Zustand des Servers 9 auf gleicher Höhe entgegenstehen.

Beispielhaft ist gemäß Figur 5 eine Sendeeinheit S der Datenschnittstelle 8a sowie eine Detektoreinheit D der Datenschnittstelle 8b dargestellt. Es ist jedoch freilich denkbar, dass auch die Datenschnittstelle 8a eine Detektoreinheit beziehungsweise die Datenschnittstelle 8b eine entsprechende Sendeeinheit aufweisen. Insbesondere können die jeweiligen Datenschnittstellen bidirektional ausgestaltet sein. Hier sei jedoch beispielhaft der Datenaustausch von der Datenschnittstelle 8a an die Datenschnittstelle 8b illustriert.

Die Datenschnittstellen 8a und 8b sind jeweils auf einem Systemboard Board 1 und Board 2 montiert. Die Systemboards Board 1 und Board 2 stellen sowohl die mechanische als auch die elektronische Plattform für die Datenschnittstellen 8ä und 8b zur Verfügung. Die Sende- beziehungsweise Detektoreinheiten S und D sind jeweils in die Systemboards Board 1 und Board 2 integriert. Die Sendeeinheit S kann beispielsweise in Form von einer oder mehreren Laserlicht emittierenden Oberflächendioden (VCSEL = Vertical Cavity Surface Emitting Laser) ausgeführt sein. Derartige Laserdioden haben den Vorteil, dass sie gering in den Herstellungskosten sowie im Stromverbrauch sind und dennoch eine hohe Einkoppeleffizienz zum Einkoppeln von Lichtwellen in Glasfasern ermöglichen.

Die Detektoreinheit D kann beispielsweise in Form von Photodioden, weiteren Photodetektoren oder -sensoren oder elektrooptischen Wandlern gebildet sein. Es ist auch denkbar, ganze Felder beziehungsweise Matrixanordnungen von Photodetektoren vorzusehen, um Lichtwellen in einem zweidimensionalen Feld zu detektieren. Dabei ist denkbar sogenannte CCD-Sensoren einzusetzen (CCD = Charge Coupled Device).

Zudem weisen die Datenschnittstellen 8a und 8b eine Optik 14a und 14b, insbesondere Linsenanordnungen L1 und L2 auf zum Bündeln und gerichteten Ein- und Auskoppeln von Lichtwellen. Eine derartige Optik 14a und 14b erlaubt schließlich eine effiziente berührungslose optische Übertragung von Lichtwellen zwischen den beiden Datenschnittstellen 8a und 8b. Die Linsen L1 und L2 der Optik 14a und 14b sind jeweils an einer Innenwand 4a des Baugruppenträgers 1 beziehungsweise an einer Außenwand 12 des Servers 9 derart angeordnet, dass sie Blickkontakt zur jeweils anderen Optik der anderen Datenschnittstelle haben.

Zur Anpassung der Feinausrichtung der beiden Datenschnittstellen 8a und 8b zueinander sowie damit verbunden zur Verbesserung eines Transmissionsgrades oder des Transmissionskoeffizienten können die Datenschnittstellen 8a und 8b, insbesondere deren Optik 14a und 14b über Justierelemente 15a und 15b feinmechanisch ausgerichtet werden. Derartige Justierelemente 15a, 15b können beispielsweise Permanent- und/oder Elektromagnete sowie Piezoelemente sein. Auf diese Weise sind die Datenschnittstellen 8a und 8b schwimmend gelagert und können beispielsweise mechanische Fertigungstoleranzen ausgleichen oder an Änderungen ihrer Ausrichtung aufgrund von Vibrationen ausgelöst durch rotierende Teile in einem entsprechenden Server 9 angepasst werden. So ist über die Justierelemente 15a und 15b beispielsweise ein Verkippen der Linsen L1 beziehungsweise L2 ermöglicht, wodurch die Richtungen der Lichtstrahlen entsprechend verändert werden können, so das weiterhin trotz feiner Veränderungen in der Ausrichtung der Datenschnittstellen 8a und 8b zueinander dennoch eine optimale Übertragung der Lichtsignale insbesondere in einen Quasi-Brennpunkt der Detektoreinheit D hinein gewährleistet ist.

Figur 5 zeigt schematisiert Strahlenbündel von Lichtstrahlen die aus der Sendeeinheit S der Datenschnittstelle 8a über die Optik L1 ausgekoppelt werden, berührungslos über die Luft an die Optik L2 der Datenschnittstelle 8b übertragen werden und dort eingefangen und in eine Detektoreinheit D hinein gebrochen und eingekoppelt werden. An die Systemboards Board 1 und Board 2 können entsprechende Lichtwellenleiter angeschlossen sein um die Lichtsignale zu führen. Die Lichtwellenleiter sind jedoch in Figur 5 der Einfachheit halber nicht dargestellt.

Die dargestellten Ausführungsformen sind lediglich beispielhaft gewählt, wobei je nach Anwendung alternative Ausführungsformen denkbar sind. Insbesondere der mechanische Aufbau eines Baugruppenträgers 1 sowie eines Servers 9 und auch die Ausführung der Datenschnittstellen 8a und 8b gemäß Figur 5 sind lediglich zur Erläuterung beispielhaft gewählt. Der wesentliche Gedanke der Erfindung liegt darin, optische Datenschnittstellen zwischen dem Baugruppenträger 1 und einem darin eingeschobenen Server 9 von einer Rückwand des Baugruppenträgers 1 fort an eine Innenwand des Baugruppenträgers 1 beziehungsweise an eine Außenwand des Servers 9 parallel zu einer Einschubrichtung des Servers 9 in den Baugruppenträger 1 hinein zu verlegen, so dass die Datenschnittstellen 8a und 8b nicht mehr in einem Kühlluftstrom durch den Baugruppenträger 1 hindurch liegen und diesen beeinträchtigen. Auf diese Weise ist an der Rückwand des Baugruppenträgers 1 freier Platz gewonnen zum Einrichten von Mitteln zur Erzeugung des Kühlluftstroms.

### Bezugszeichenliste

- 1: Baugruppenträger
- 2: Gehäuse
- 3: Einschubschacht
- 4a, 4b: Innenwände
- 5, 5a, 5b: Einschubplatz
- 6a, 6b: Datenleitung
- 7a, 7b: Endabschnitt
- 8a, 8b: Datenschnittstelle
- 9: Server
- 10: Lüfter
- 11: Vermittlungseinheit
- 12: Außenwand des Servers
- 13: Montagevorrichtung
- 14a, 14b: Optik
- 15a, 15b: Justierelement
- L1, L2: Linse
- B1, B2: Systemboard
- S: Sendeeinheit
- D: Detektoreinheit

## Patentansprüche

1. Baugruppenträger (1) mit einem Einschubschacht (3) zur Aufnahme von Servern (9), wobei der Einschubschacht (3) zwei gegenüberliegende Innenbereiche (4a, 4b) definiert, welche parallel zu einer Einschubrichtung der Server (9) angeordnet sind und Innenwände ausbilden, wobei die Innenwände in eine Vielzahl von Einschubplätzen (5) unterteilt sind, und wobei im Baugruppenträger (1) eine oder mehrere Datenleitungen (6a) zur Datenverbindung von Servern (9) eingerichtet sind, **dadurch gekennzeichnet, dass**
die Datenleitungen (6a) optische Datenleitungen umfassen, wobei an zumindest einem der zwei Innenbereiche (4a, 4b) des Einschubschachtes (3) an jedem Einschubplatz (5) ein Endabschnitt (7a) einer Datenleitung (6a) mit einer Datenschnittstelle (8a) angeordnet ist, derart dass eine berührungslose optische Datenverbindung zu einer weiteren Datenschnittstelle (8b) an einem entsprechenden Server (9) ermöglicht ist.

2. Baugruppenträger (1) nach Anspruch 1, **dadurch gekennzeichnet, dass** der Baugruppenträger (1) ein Serverrack ist.

3. Baugruppenträger (1) nach Anspruch 1, **dadurch gekennzeichnet, dass** der Baugruppenträger (1) ein Bladeservergehäuse ist.

4. Baugruppenträger (1) nach einem der Ansprüche 1 bis 3, **dadurch gekennzeichnet, dass** im Baugruppenträger (1) Mittel (10) eingerichtet sind zur Erzeugung eines Kühlluftstromes derart, dass die Richtung des Kühlluftstroms parallel zur Einschubrichtung der Server (9) ausgebildet ist.

5. Baugruppenträger (1) nach einem der Ansprüche 1 bis 4, **dadurch gekennzeichnet, dass** die Endabschnitte (7a) der Datenleitungen (6a) mit den Datenschnittstellen (8a) zu einem entsprechenden Server (9) hin gerichtet sind und jeweils einen Lichtwellenleiter, insbesondere ein Glasfaserkabel, sowie eine daran anschließende Optik (14a), insbesondere eine Anordnung mit zumindest einer Linse (L1), zum Ein- und Auskoppeln von Lichtwellen umfassen.

6. Baugruppenträger (1) nach Anspruch 5, **dadurch gekennzeichnet, dass** die Endabschnitte (7a) jeweils eine Anordnung von einem oder mehreren Justierelementen (15a) aufweisen, die zum feinmechanischen Ausrichten der Optik (14a) eingerichtet sind.

7. Baugruppenträger (1) nach einem der Ansprüche 1 bis 6, **dadurch gekennzeichnet, dass** die Endabschnitte (7a) in ihrer Position an den Einschubplätzen (5) veränderlich sind.

8. Baugruppenträger (1) nach einem der Ansprüche 1 bis 7, **dadurch gekennzeichnet, dass** die Datenleitungen (6a) im Baugruppenträger (1) geführt sind und mit einer im Baugruppenträger (1) angeordneten Vermittlungseinheit (11) verbunden sind zum selektiven Verschalten von Servern (9).

9. Server (9), welcher dazu eingerichtet ist, in einen Einschubplatz eines Baugruppenträgers gemäß Anspruch 1 (1) eingeschoben zu werden, wobei der Server (9) zumindest an einer Außenwand (12) einen Endabschnitt (7b) einer optischen Datenleitung (6b) mit einer Datenschnittstelle (8b) aufweist, welche dazu eingerichtet ist, eine berührungslose optische Datenverbindung zu der Datenschnittstelle (8a) des Baugruppenträgers (1) zu ermöglichen,
**dadurch gekennzeichnet, dass**
der Endabschnitt (7b) in seiner Position an der Außenwand (12) des Servers (9) veränderlich ist.

10. Server (9) nach Anspruch 9,
**dadurch gekennzeichnet, dass** der Server (9) ein Rackserver ist.

11. Server (9) nach Anspruch 9,
**dadurch gekennzeichnet, dass** der Server (9) ein Bladeserver ist.

12. Server (9) nach einem der Ansprüche 9 bis 11,
**dadurch gekennzeichnet, dass** im Server (9) Mittel eingerichtet sind zur Erzeugung eines Kühlluftstromes durch den Server (9) derart, dass die Richtung des Kühlluftstroms parallel zu einer Einschubrichtung des Servers (9) in einem Baugruppenträger (1) ausgebildet ist.

13. Server (9) nach einem der Ansprüche 9 bis 12,
**dadurch gekennzeichnet, dass** der Endabschnitt (7b) der Datenleitung (6b) mit der Datenschnittstelle (8b) einen Lichtwellenleiter, insbesondere ein Glasfaserkabel, sowie eine daran anschließende Optik (14b), insbesondere eine Anordnung mit zumindest einer Linse (L2), zum Ein- und Auskoppeln von Lichtwellen umfasst.

14. Server (9) nach Anspruch 13,
**dadurch gekennzeichnet, dass** der Endabschnitt (7b) im Server (9) jeweils eine Anordnung von einem oder mehreren Justierelementen (15b) aufweist, die zum feinmechanischen Ausrichten der Optik (14b) eingerichtet sind.

15. Anordnung mit einem Baugruppenträger (1) nach einem der Ansprüche 1 bis 8 und zumindest einem Server (9), welcher in einen Einschubplatz (5) des Einschubschachts (3) eingeschoben ist, wobei der Server (9) zumindest an einer Außenwand (12) einen Endabschnitt (7b) einer optischen Datenleitung (6b) mit einer Datenschnittstelle (8b) aufweist, welche dazu eingerichtet ist, eine berührungslose optische Datenverbindung zu einer Datenschnittstelle (8a) des Baugruppenträgers (1) zu ermöglichen, wobei die Außenwand (12) des Servers (9) parallel zum entsprechenden Innenbereich (4a, 4b) am Einschubplatz (5) angeordnet ist, und wobei die Datenschnittstelle (8b) des Servers (9) derart auf Höhe der Datenschnittstelle (8a) des Einschubplatzes (5) angeordnet ist, dass eine berührungslose optische Datenverbindung zwischen den beiden Datenschnittstellen (8a, 8b) ermöglicht ist.

16. Anordnung nach Anspruch 15, wobei der Server gemäß einem der Ansprüche 9 bis 14 eingerichtet ist.

## Claims

1. Rack (1) with a mouting bay (3) to accommodate servers (9), wherein the mouting bay (3) defines two opposing internal areas (4a, 4b) which are disposed parallel to an insertion direction of the servers (9) and form internal walls, wherein the internal walls are divided into a multiplicity of slots (5), and wherein one or more data lines (6a) for the data connection of servers (9) are configured in the rack (1), **characterized in that**
the data lines (6a) comprise optical data lines, wherein, on at least one of the two internal areas (4a, 4b) of the mouting bay (3), an end section (7a) of a data line (6a) with a data interface (8a) is disposed on each slot (5) in such a way that a contactless optical data connection to a further data interface (8b) on a corresponding server (9) is enabled.

2. Rack (1) according to Claim 1, **characterized in that** the rack (1) is a server rack.

3. Rack (1) according to Claim 1, **characterized in that** the rack (1) is a blade server housing.

4. Rack (1) according to one of Claims 1 to 3, **characterized in that** means (10) are configured in the rack (1) to generate a cooling airstream in such a way that the direction of the cooling airstream is parallel to the insertion direction of the servers (9).

5. Rack (1) according to one of Claims 1 to 4, **characterized in that** the end sections (7a) of the data lines (6a) with the data interfaces (8a) are directed towards a corresponding server (9) and in each case comprise an optical waveguide, in particular an optical fiber cable, and an optical system (14a) connected thereto, in particular an assembly with at least one lens (L1), for the insertion and extraction of light waves.

6. Rack (1) according to Claim 5, **characterized in that** the end sections (7a) in each case have an assembly of one or more adjusting elements (15a) which are configured for the fine-mechanical alignment of the optical system (14a).

7. Rack (1) according to one of Claims 1 to 6, **characterized in that** the end sections (7a) are variable in their position on the slots (5).

8. Rack (1) according to one of Claims 1 to 7, **characterized in that** the data lines (6a) are routed in the rack (1) and are connected to a switching unit (11) disposed in the rack (1) for the selective connection of servers (9).

9. Server (9) which is configured to be inserted into a slot of a rack (1) according to Claim 1, wherein the server (9), at least on one external wall (12), has an end section (7b) of an optical data line (6b) with a data interface (8b) which is configured to enable a contactless optical data connection to the data interface (8a) of the rack (1),
**characterized in that** the end section (7b) is variable in its position on the external wall (12) of the server (9).

10. Server (9) according to Claim 9,
**characterized in that** the server (9) is a rack server.

11. Server (9) according to Claim 9,
**characterized in that** the server (9) is a blade server.

12. Server (9) according to one of Claims 9 to 11, **characterized in that** means are configured in the server (9) to generate a cooling airstream through the server (9) in such a way that the direction of the cooling airstream is formed parallel to an insertion direction of the server (9) in a rack (1).

13. Server (9) according to one of Claims 9 to 12, **characterized in that** the end section (7b) of the data line (6b) with the data interface (8b) comprises an optical waveguide, in particular an optical fiber cable, and an optical system (14b) connected thereto, in particular an assembly with at least one lens (L2), for the insertion and extraction of light waves.

14. Server (9) according to Claim 13,
**characterized in that** the end section (7b) in the server (9) in each case has an assembly of one or more adjusting elements (15b) which are configured for the fine-mechanical alignment of the optical system (14b).

15. An assembly with a rack (1) according to one of Claims 1 to 8 and at least one server (9) which is inserted into a slot (5) of the mouting bay (3), wherein, at least on one external wall (12), the server (9) has an end section (7b) of an optical data line (6b) with a data interface (8b) which is configured to enable a contactless optical data connection to a data interface (8a) of the rack (1), wherein the external wall (12) of the server (9) is disposed parallel to the corresponding internal area (4a, 4b) on the slot (5), and wherein the data interface (8b) of the server (9) is disposed level with the data interface (8a) of the slot (5) in such a way that a contactless optical data connection between the two data interfaces (8a, 8b) is enabled.

16. Assembly according to Claim 15, wherein the server is configured according to one of Claims 9 to 14.

## Revendications

1. Châssis (1) avec une baie de montage (3) destiné à loger des serveurs (9), la baie de montage (3) définissant deux régions intérieures (4a, 4b) opposées, lesquelles sont placées à la parallèle du sens d'insertion des serveurs (9) et forment des parois intérieures, les parois intérieures étant subdivisées en une pluralité d'emplacements d'insertion (5) et dans le châssis (1) étant insérée(s) une ou plusieurs lignes de transmission de données (6a) pour la liaison de données de serveurs (9), **caractérisé en ce que** les lignes de transmission de données (6a) comprennent des lignes de transmission de données optiques, sur au moins l'une des deux régions intérieures (4a, 4b) de la baie de montage (3), sur chaque emplacement d'insertion (5) étant placée une partie d'extrémité (7a) d'une ligne de transmission de données (6a) avec une interface de données (8a), de telle sorte qu'une liaison de données optique sans contact vers une autre interface de données (8b) sur un serveur (9) correspondant soit rendue possible.

2. Châssis (1) selon la revendication 1, **caractérisé en ce que** le châssis (1) est un support de serveur.

3. Châssis (1) selon la revendication 1, **caractérisé en ce que** le châssis (1) est un boîtier de serveur lame.

4. Châssis (1) selon l'une quelconque des revendications 1 à 3, **caractérisé en ce que** dans le châssis (1) sont installés des moyens (10) pour la création d'un flux d'air de refroidissement, de telle sorte que la direction du flux d'air de refroidissement soit conçue à la parallèle du sens d'insertion des serveurs (9).

5. Châssis (1) selon l'une quelconque des revendications 1 à 4, **caractérisé en ce que** les parties d'extrémité (7a) des lignes de transmission de données (6a) avec les interfaces de données (8a) sont orientées en direction d'un serveur (9) correspondant et comprennent chacune un guide d'ondes optiques, notamment un câble à fibres optiques, ainsi qu'une optique (14a) qui s'y raccorde, notamment un agencement avec au moins une lentille (L1) pour le couplage et le découplage d'ondes optiques.

6. Châssis (1) selon la revendication 5, **caractérisé en ce que** les parties d'extrémité (7a) comportent chacune un agencement d'un ou de plusieurs élément(s) d'ajustage (15a), qui sont installés pour l'orientation mécanique de précision de l'optique (14a).

7. Châssis (1) selon l'une quelconque des revendications 1 à 6, **caractérisé en ce que** les parties d'extrémité (7a) sont variables en position sur les emplacements d'insertion (5).

8. Châssis (1) selon l'une quelconque des revendications 1 à 7, **caractérisé en ce que** les lignes de transmission de données (6a) sont guidées dans le châssis (1) et sont reliées avec une unité de commutation (11) placée dans le châssis (1), pour l'interconnexion sélective de serveurs (9).

9. Serveur (9), lequel est aménagé pour être inséré dans un emplacement d'insertion d'un châssis (1) selon la revendication 1, le serveur (9) comportant au moins sur une paroi extérieure (12) une partie d'extrémité (7b) d'une ligne de transmission de données (6b) optique, avec une interface de données (8b), laquelle est aménagée pour permettre une liaison de données optique sans contact vers l'interface de données (8a) du châssis (1), **caractérisé en ce que** la partie d'extrémité (7b) est variable en position sur la paroi extérieure (12) du serveur (9).

10. Serveur (9) selon la revendication 9, **caractérisé en ce que** le serveur (9) est un serveur rack.

11. Serveur (9) selon la revendication 9, **caractérisé en ce que** le serveur (9) est un serveur lame.

12. Serveur (9) selon l'une quelconque des revendications 9 à 11, **caractérisé en ce que** dans le serveur (9) sont installés des moyens pour la création d'un flux d'air de refroidissement à travers le serveur (9), de telle sorte que la direction du flux d'air de refroidissement soit conçue à la parallèle d'un sens d'insertion du serveur (9) dans un châssis (1).

13. Serveur (9) selon l'une quelconque des revendications 9 à 12, **caractérisé en ce que** la partie d'extrémité (7b) de la ligne de transmission de données (6b) comprend avec l'interface de données (8b). un guide d'ondes optiques, notamment un câble à fibres optiques, ainsi qu'une optique (14b) qui s'y raccorde, notamment un agencement avec au moins une lentille (L2) pour le couplage et le découplage d'ondes optiques.

14. Serveur (9) selon la revendication 13, **caractérisé en ce que** la partie d'extrémité (7b) dans le serveur (9) comporte respectivement un agencement d'un ou de plusieurs élément(s) d'ajustage (15b), qui est aménagé pour l'orientation mécanique de précision de l'optique (14b).

15. Agencement avec un châssis (1) selon l'une quelconque des revendications 1 à 8 et au moins un serveur (9), lequel est inséré dans l'emplacement d'insertion (5) de la baie de montage (3), le serveur (9) comportant au moins sur une paroi extérieure (12) une partie d'extrémité (7b) d'une ligne de transmission de données (6b) optique avec une interface de données (8b), laquelle est aménagée pour permettre une liaison de données optique sans contact vers une interface de données (8a) du châssis (1), la paroi extérieure (12) du serveur (9) étant placée à la parallèle de la région intérieure (4a, 4b) correspondante sur l'emplacement d'insertion (5) et l'interface de données (8b) du serveur (9) étant placée au niveau de l'interface de données (8a) de l'emplacement d'insertion (5), de telle sorte qu'une liaison de données optique sans contact entre les deux interfaces de données (8a, 8b) soit rendue possible.

16. Agencement selon la revendication 15, le serveur étant aménagé selon l'une quelconque des revendications 9 à 14.
